# EUROPÄISCHE PATENTSCHRIFT

(11) **EP 2 248 235 B1**
(45) Veröffentlichungstag und Bekanntmachung des Hinweises auf die Patenterteilung: **20.12.2017**
(21) Anmeldenummer: 09715490.0
(22) Anmeldetag: 28.01.2009
(51) Int. Cl.: H01S 5/22, H01L 21/02, H01L 33/12, H01L 33/32, H01L 33/00, H01L 33/10, H01S 5/02, H01S 5/042, H01S 5/12, H01S 5/183, H01S 5/323

(54) **KANTENEMITTIERENDER HALBLEITERLASER UND VERFAHREN ZUR HERSTELLUNG EINES KANTENEMITTIERENDEN HALBLEITERLASERS**
EDGE-EMITTING SEMICONDUCTOR LASER AND METHOD FOR PRODUCING AN EDGE-EMITTING SEMICONDUCTOR LASER
LASER À SEMI-CONDUCTEURS À ÉMISSION PAR LA TRANCHE ET PROCÉDÉ DE FABRICATION D'UN LASER À SEMI-CONDUCTEURS À ÉMISSION PAR LA TRANCHE

(30) Priorität: 29.02.2008 DE 102008011864; 17.04.2008 DE 102008019268
(43) Veröffentlichungstag der Anmeldung: 10.11.2010
(73) Patentinhaber: OSRAM Opto Semiconductors GmbH, 93055 Regensburg (DE)
(72) Erfinder: AVRAMESCU, Adrian Stefan, 93051 Regensburg (DE); EICHLER, Christoph, 93105 Tegernheim (DE); STRAUSS, Uwe, 93077 Bad Abbach (DE); HÄRLE, Volker, 93164 Laaber (DE)
(74) Vertreter: Epping - Hermann - Fischer
(86) Internationale Anmeldenummer: PCT/DE2009/000116
(87) Internationale Veröffentlichungsnummer: WO 2009/106028

(56) Entgegenhaltungen:
- EP-A- 1 387 414
- EP-A- 1 508 923
- WO-A1-2007/105882
- DE-A1-102006 023 685
- US-A1- 2003 006 409

## Beschreibung

Kantenemittierender Halbleiterlaser und Verfahren zur Herstellung eines kantenemittierenden Halbleiterlasers Die Erfindung betrifft einen kantenemittierenden Halbleiterlaser gemäß dem Oberbegriff des Patentanspruchs 1 und ein Verfahren zu dessen Herstellung.

Bei optoelektronischen Halbleiterbauelementen, beispielsweise Halbleiterlasern oder LEDs, korreliert die Lebensdauer des Bauelements unter anderem mit der Anzahl der Defekte in den epitaktisch aufgewachsenen Halbleiterschichten. Durch eine hohe Anzahl von Defekten wird auch die interne Quanteneffizienz vermindert, wodurch sich die Lichtausbeute verringert. Zum epitaktischen Aufwachsen von Halbleiterschichten mit geringer Defektdichte ist ein Aufwachssubstrat von hoher Qualität erforderlich.
Zur Herstellung von optoelektronischen Bauelementen auf der Basis von Nitridverbindungshalbleitern ist es schwierig, geeignete Aufwachssubstrate bereitzustellen, die eine zum Aufwachsen von Nitridverbindungshalbleitern geeignete Gitterkonstante aufweisen und sich gleichzeitig durch eine geringe Defektdichte an ihrer Oberfläche auszeichnen.
Es ist bekannt, epitaktische Halbleiterschichten aus Nitridverbindungshalbleitern auf SiC- oder Saphirsubstraten aufzuwachsen. Beim Aufwachsen auf derartigen Aufwachssubstraten entstehen an der Grenzfläche zwischen dem Aufwachssubstrat und den epitaktischen Halbleiterschichten allerdings vergleichsweise viele Defekte, die sich vom Aufwachssubstrat durch das Bauelement erstrecken und deshalb auch als "threading dislocations" bezeichnet werden. Die Defekte weisen typischerweise eine Flächendichte (threading dislocation density , TDD) von typischerweise mehr als 10⁸ cm⁻² auf.

Inzwischen stehen zum epitaktischen Aufwachsen von Nitridverbindungshalbleitern zwar Substrate aus GaN zur Verfügung, die eine vergleichsweise geringe Defektdichte von typischerweise mehr als 10⁵ cm⁻² aufweisen. Allerdings erschwert der hohe Preis derartiger GaN-Substrate den kommerziellen Einsatz in der Massenproduktion von optoelektronischen Bauelementen auf der Basis von Nitridverbindungshalbleitern.

Ein weiterer Nachteil bei der Verwendung von GaN-Substraten besteht darin, dass die epitaktischen Schichten des optoelektronischen Bauelements nicht ohne weiteres von dem Aufwachssubstrat abgelöst werden können, um sogenannte Dünnfilmbauelemente herzustellen. Solche Dünnfilmbauelemente können nach dem Aufwachsen der Epitaxieschichtenfolge auf einem Saphirsubstrat beispielsweise mittels eines Laser-Lift-Off-Prozesses hergestellt werden. Bei dem Laser-Lift-Off-Verfahren wird Laserstrahlung durch das transparente Aufwachssubstrat eingestrahlt und an der Grenzfläche zwischen dem Aufwachssubstrat und der Epitaxieschichtenfolge absorbiert, wobei durch die Absorption der Laserstrahlung eine Materialzersetzung an der Grenzfläche erzielt wird, die zum Ablösen des Aufwachssubstrats führt. Ein derartiges Laser-Lift-Off-Verfahren ist beispielsweise aus der Druckschrift WO 98/14986 bekannt. Im Gegensatz zu Substraten aus Saphir kann dieses Verfahren bei Substraten aus GaN in der Regel jedoch nicht ohne weiteres angewandt werden, da das GaN-Aufwachssubstrat nicht transparent ist.

In der Druckschrift EP 1 508 923 A2 wird ein optoelektronisches Bauelement beschrieben, das ein Aufwachssubstrat aus AlGaN aufweisen kann. Die Druckschrift EP 1 387 414 A1 offenbart ein optoelektronisches Bauelement, das ein Substrat aus AlInGaN aufweisen kann.

Die Druckschrift US 2003/0006409 A1 beschreibt einen kantenemittierenden Halbleiterlaser, der auf einem Aufwachssubstrat aus Saphir einen Schichtenstapel aus mehreren einkristallinen Schichten aus Al(Ga)N-Materialien enthält, wobei auf diesen Schichtenstapel die funktionelle Halbleiterschichtenfolge aufgewachsen ist. Die funktionelle Halbleiterschichtenfolge enthält insbesondere eine n-Typ Mantelschicht, eine erste optische Wellenleiterschicht, eine aktive Schicht, eine zweite optische Wellenleiterschicht und eine p-Typ Mantelschicht.

Der Erfindung liegt die Aufgabe zugrunde, einen kantenemittierenden Halbleiterlaser anzugeben, der sich durch eine geringe Defektdichte und einen vergleichsweise geringen Herstellungsaufwand auszeichnet. Weiterhin ist es Aufgabe der Erfindung, ein Verfahren zur Herstellung eines kantenemittierenden Halbleiterlasers anzugeben, mit dem eine geringe Defektdichte bei geringen Herstellungskosten erzielt wird. Insbesondere soll die Möglichkeit bestehen, das Aufwachssubstrat mittels eines Laser-Lift-Off-Verfahrens von der Epitaxieschichtenfolge abzulösen.

Diese Aufgabe wird durch einen kantenemittierenden Halbleiterlaser mit den Merkmalen des Patentanspruchs 1 und ein Verfahren zu dessen Herstellung gemäß Patentanspruch 3 gelöst. Vorteilhafte Ausgestaltungen und Weiterbildungen der Erfindung sind Gegenstand der abhängigen Ansprüche.

Ein kantenemittierender Halbleiterlaser gemäß der Erfindung, der eine einem Nitridverbindungshalbleiter basierende Epitaxieschichtenfolge mit einer aktiven Schicht enthält, weist ein Aufwachssubstrat aus Al₁₋ₓ(In_{y}Ga_{1-y})ₓN oder In₁₋ₓGaₓN mit 0 < x < 0,99 und 0 ≤ y ≤ 1 auf. Bevorzugt ist x < 0,95.

Die Epitaxieschichtenfolge ist epitaktisch auf dem Aufwachssubstrat aufgewachsen, so dass ihre Gitterkonstante in einer Richtung parallel zur Schichtebene (in-plane-Gitterkonstante) bevorzugt im wesentlichen durch die in-plane-Gitterkonstante des Aufwachssubstrats bestimmt wird.

Ein derartiges Aufwachssubstrat aus Al₁₋ₓ(In_{y}Ga_{1-y})ₓN oder In₁₋ₓGaₓN mit 0 < x < 0,99 und 0 ≤ y ≤ 1 kann vergleichsweise einfach als Bulk-Material durch Kristallwachsverfahren hergestellt werden und ist daher vergleichsweise kostengünstig. Dies beruht insbesondere darauf, dass die Bindungskräfte der Atome an der Oberfläche dieser ternären und quaternären Nitridverbindungshalbleiter stärker als die Bindungskräfte an der Oberfläche von reinem GaN sind. Die vergleichsweise stabile Kristalloberfläche begünstigt das Kristallwachstum, insbesondere die Herstellung von Einkristallen. Weiterhin zeichnet sich ein derartiges Aufwachssubstrat vorteilhaft durch die intrinsischen Eigenschaften des Bulk-Materials aus. Die Defektdichte(Threading Dislocation Density, TDD) des Aufwachssubstrats beträgt vorteilhaft weniger als 10⁷ cm⁻², besonders bevorzugt weniger als 10⁶ cm⁻².

Die geringe Defektdichte des Aufwachssubstrats wirkt sich positiv auf die Kristallqualität der Epitaxieschichtenfolge aus. Dadurch erhöhen sich vorteilhaft die Lebensdauer des optoelektronischen Bauelements, insbesondere bei Hochleistungsbauelementen wie Halbleiterlasern, und die Quanteneffizienz bei der Strahlungserzeugung.

Bei dem Aufwachssubstrat kann es sich um ein freitragendes Substrat handeln. Alternativ kann das Aufwachssubstrat aber auch eine sogenanntes Quasisubstrat sein. Unter einem "Quasisubstrat" wird im Rahmen dieser Anmeldung eine dünne Schicht verstanden, die zuvor von einem Halbeleitersubstrat aus dem jeweiligen Halbleitermaterial abgelöst und auf einen anderen Träger übertragen wurde.

Ein derartiges Verfahren zum Übertragen einer dünnen Schicht eines Halbleitersubstrats auf einen anderen Träger ist an sich aus der Druckschrift US 5,374,564 bekannt. Dabei werden Ionen durch eine Oberfläche des Halbleitersubstrats implantiert und auf diese Weise eine Ionenimplantationszone in dem Halbleitersubstrat erzeugt. Danach wird das Substrat an dieser Oberfläche, zum Beispiel mittels einer Zwischenschicht wie insbesondere einer Lotschicht, auf dem Träger befestigt. Nachfolgend wird das Halbleitersubstrat entlang der Ionenimplantationszone mittels Tempern zertrennt, so dass eine dünne Schicht des ursprünglichen Halbleitersubstrats auf dem Träger verbleibt und als Aufwachssubstrat, zum Beispiel zum epitaktischen Aufwachsen einer Epitaxieschichtenfolge eines optoelektronischen Bauelements, verwendet werden kann.

Die als Aufwachssubstrat fungierende dünne Schicht auf dem Träger zeichnet sich insbesondere dadurch aus, dass ihre in-plane-Gitterkonstante im wesentlichen durch die Zusammensetzung des Halbleitermaterials bestimmt ist und somit nicht oder nur unwesentlich durch den Träger beeinflusst ist. Sie unterscheidet sich dadurch von einer dünnen epitaktisch aufgewachsenen Schicht, deren in-plane Gitterkonstante im wesentlichen durch das Aufwachssubstrat bestimmt ist. Im Gegensatz zu einer auf den Träger übertragenen Schicht würde sich bei einer epitaktisch aufgewachsenen Schicht die Gitterkonstante erst bei großen Schichtdicken durch die Ausbildung von Defekten einer der Materialzusammensetzung entsprechenden Gitterkonstante anpassen.

Die Epitaxieschichtenfolge des kantenemittierenden Halbleiterlasers basiert auf einem Nitridverbindungshalbeiter. "Auf einem Nitridverbindungshalbleiter basierend" bedeutet im vorliegenden Zusammenhang, dass die Epitaxieschichtenfolge oder zumindest die aktive Schicht ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die aktive Schicht kann insbesondere eine strahlungsemittierende aktive Schicht sein. Die aktive Schicht kann zum Beispiel als pn-Übergang, als Doppelheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Zwischen dem Aufwachssubstrat und der Epitaxieschichtenfolge sind mehrere Pufferschichten aus In_{y}AlₓGa_{1-x-y}N mit x < 0,9 und y < 0,1 angeordnet. Die Differenz der Gitterkonstanten zwischen den benachbarten Pufferschichten wird vorzugsweise jeweils derart gering gehalten, dass keine zusätzlichen Defekte durch mechanische Verspannungen entstehen. Die Epitaxieschichtenfolge des kantenemittierenden Halbleiterlasers kann dadurch vorteilhaft auf die oberste der Pufferschichten aufgewachsen werden, die sich vorteilhaft durch eine gute Gitteranpassung an die epitaktischen Schichten und eine geringe Defektdichte auszeichnet.

Durch die zwischen dem Aufwachssubstrat und der Epitaxieschichtenfolge des kantenemittierenden Halbleiterlasers angeordneten Pufferschichten wird vorteilhaft ein stufenförmiger oder gradientenförmiger Übergang der Gitterkonstante von dem Aufwachssubstrats auf die Epitaxieschichtenfolge erzielt, wodurch mechanische Spannungen vorteilhaft vermindert werden.
Bei dem kantenemittierenden Halbleiterlaser ist die aktive Schicht zwischen zwei Wellenleiterschichten angeordnet, die einen Wellenleiter ausbilden, in dem sich die von der aktiven Schicht emittierte Strahlung in der Hauptabstrahlungsrichtung ausbreiten kann. Bei einem herkömmlichen kantenemittierenden Halbleiterlaser grenzen auf beiden Seiten der aktiven Schicht jeweils Mantelschichten an die Wellenleiterschichten an, die einen geringeren Brechungsindex aufweisen als die Wellenleiterschichten, so dass der Brechungsindexsprung eine optische Führung der Welle in dem Wellenleiter bewirkt.
Da das Aufwachssubstrat und/oder die Pufferschichten bei dem kantenemittierenden Halbleiterlaser aufgrund ihres Aluminiumgehalts einen vergleichsweise geringen Brechungsindex aufweisen, wird bei dem erfindungsgemäßen kantenemittierenden Halbleiterlaser vorteilhaft auf die von der aktiven Schicht aus gesehen dem Aufwachssubstrat zugewandte Mantelschicht verzichtet. Es folgt also nur der von der aktiven Schicht aus gesehen dem Aufwachssubstrat gegenüber liegenden Wellenleiterschicht eine Mantelschicht nach und zwischen dem Aufwachssubstrat und der dem Aufwachssubstrat zugewandten Wellenleiterschicht ist keine Mantelschicht angeordnet. Dadurch ist der Herstellungsaufwand vorteilhaft vermindert und die Wärmeabfuhr in Richtung des Aufwachssubstrats verbessert sich aufgrund der geringen Gesamtschichtdicke der Epitaxieschichtenfolge.
Zur Wärmeabfuhr der beim Betrieb des kantenemittierenden Halbleiterlasers entstehenden Wärme ist das Aufwachssubstrat an der von der aktiven Schicht abgewandten Seite vorzugsweise auf eine Wärmesenke montiert. Bei der Wärmesenke kann es sich um eine passive Wärmesenke, beispielsweise einen Kupferblock, oder eine aktive Wärmesenke, beispielsweise um einen Mikrokanalkühler, handeln. Hierbei ist es von Vorteil, dass das Aufwachssubstrat aus Al₁₋ₓ(In_{y}Ga_{1-y})ₓN oder In₁₋ₓGaₓN mit 0 < x < 0,99 und 0 ≤ y ≤ 1 im Vergleich zu dem herkömmlicherweise verwendeten Substraten aus Saphir oder GaN eine verbesserte Wärmeleitfähigkeit aufweist. Somit kann die in der aktiven Schicht erzeugte Wärme effektiv über das Aufwachssubstrat an die Wärmesenke abgeführt werden.

Bei einem Verfahren zur Herstellung eines kantenemittierenden Halbleiterlasers gemäß der Erfindung wird ein Aufwachssubstrat aus Al₁₋ₓ(In_{y}Ga_{1-y})ₓN oder In₁₋ₓGaₓN mit 0 < x < 0,99 und 0 ≤ y ≤ 1 bereitgestellt, und nachfolgend eine auf einem Nitridverbindungshalbleiter basierende Epitaxieschichtenfolge, die eine aktive Schicht aufweist, auf das Aufwachssubstrat aufgewachsen.

Vor dem Aufwachsen der Epitaxieschichtenfolge werden mehrere Pufferschichten In_{y}AlₓGa_{1-x-y}N mit x < 0,9 und y < 0,1 auf das Aufwachssubstrat aufgebracht.

Bei einer weiteren vorteilhaften Ausgestaltung wird vor dem Aufwachsen der Epitaxieschichtenfolge oder gegebenenfalls der mehreren Pufferschichten eine Temperaturbehandlung des Aufwachssubstrats durchgeführt. Mittels der Temperaturbehandlung können vorteilhaft Oxide und Kohlenstoffverbindungen von der Oberfläche des Aufwachssubstrats entfernt werden. Die Temperaturbehandlung wird vorteilhaft bei einer Temperatur von mehr als 1000 °C, vorzugsweise bei einer Temperatur zwischen 1000 °C und 1100 °C, durchgeführt. Die Temperaturbehandlung erfolgt vorzugsweise in situ, dass heißt in der zum Aufwachsen der Epitaxieschichtenfolge vorgesehenen Hochvakuumkammer. Vorzugsweise erfolgt die Temperaturbehandlung unter Zufuhr von H₂-Gasoder NH₃-Gas.

Bei einer bevorzugten Ausführungsform des erfindungsgemäßen Verfahrens wird das Aufwachssubstrat nach dem Aufwachsen der Epitaxieschichtenfolge abgelöst.

Das Ablösen des Aufwachssubstrats von der Epitaxieschichtenfolge erfolgt vorteilhaft mittels eines Laser-Lift-Off-Verfahrens. Das Laser-Lift-Off-Verfahren kann insbesondere dann angewandt werden, wenn das Aufwachssubstrat für Strahlung, die von der Epitaxieschichtenfolge absorbiert wird, transparent ist, so dass die Laserstrahlung durch das Substrat in die Epitaxieschichten eingestrahlt werden kann. Dieses Verfahren kann daher insbesondere bei einem Aufwachssubstrat aus Al₁₋ₓ(In_{y}Ga_{1-y})ₓN mit x < 0,99 im Gegensatz zu GaN-Substraten angewandt werden, da das Aufwachssubstrat aufgrund des Aluminiumanteils eine größere elektronische Bandlücke aufweist als GaN. Der Aluminiumanteil des Aufwachssubstrats wird vorteilhaft so gewählt, dass das Aufwachssubstrat für Strahlung, die von der Epitaxieschichtenfolge absorbiert wird, transparent ist.

Eine alternative Möglichkeit zur Ablösung des Aufwachssubstrats von der Epitaxieschichtenfolge besteht darin, dass vor dem Aufwachsen der Epitaxieschichtenfolge eine Opferschicht auf das Aufwachssubstrat aufgebracht wird, wobei das Aufwachssubstrat nachfolgend durch selektives Ätzen der Opferschicht entfernt wird.

Bevorzugt wird die Epitaxieschichtenfolge vor dem Ablösen des Aufwachssubstrats an der dem Aufwachssubstrat gegenüberliegenden Oberfläche mit einem Träger verbunden. Das Ablösen des Aufwachssubstrats von der Epitaxieschichtenfolge und die Verbindung der Epitaxieschichtenfolge mit einem anderen Träger hat den Vorteil, dass der Träger nicht für das epitaktische Aufwachsen eines Nitridverbindungshalbleiters geeignet sein muss. Es besteht daher eine große Auswahl an geeigneten Materialien für den Träger. Insbesondere kann der Träger aus einem Material bestehen, dass sich eine gute elektrische und/oder thermische Leitfähigkeit und/oder durch geringe Kosten auszeichnet. Beispielsweise kann der Träger aus Ge, GaAs, Si, SiC, einem Metall wie beispielsweise Mo oder Au, einer Metalllegierung, oder einer Keramik wie zum Beispiel AlN gebildet sein.

Die Epitaxieschichtenfolge wird vorzugsweise derart auf das Aufwachssubstrat aufgewachsen, dass zuerst ein Bereich n-dotierter Halbleiterschichten und nachfolgend ein Bereich p-dotierter Halbleiterschichten aufgewachsen wird, wobei die aktive Schicht zwischen dem Bereich n-dotierter Halbleiterschichten und dem Bereich p-dotierter Halbleiterschichten angeordnet ist. Wenn das Aufwachssubstrat nach dem Aufwachsen der Epitaxieschichtenfolge abgelöst wird, ist somit im Gegensatz zu herkömmlichen optoelektronischen Bauelementen der Bereich n-dotierter Halbleiterschichten einer Strukturierung zugänglich.

Vorzugsweise wird in dem Bereich der n-dotierten Halbleiterschichten nach dem Ablösen des Aufwachssubstrats eine Strukturierung durchgeführt. Beispielsweise kann der Bereich der n-dotierten Halbleiterschichten zu einem Rippenwellenleiter strukturiert werden, wobei der Rippenwellenleiter-Laser vorzugsweise an der Seite der p-dotierten Halbleiterschichten ganzflächig auf einen Träger montiert ist.

Das Strukturieren der n-dotierten Halbleiterschichten hat im Vergleich zu herkömmlichen optoelektronischen Bauelementen, bei denen in der Regel der Bereich der p-dotierten Halbleiterschichten strukturiert wird, den Vorteil, dass eine größere Anzahl an geeigneten Plasmaprozessen zur Durchführung der Strukturierung zur Verfügung steht. Es hat sich herausgestellt, dass bei einer Strukturierung von p-dotierten Halbleiterschichten bei einigen Plasmaprozessen die Gefahr besteht, dass die elektrischen Eigenschaften der Schichten bei der Durchführung des Plasmaprozesses degradieren. Im Gegensatz dazu ist der Bereich der n-dotierten Halbleiterschichten weniger empfindlich, so dass die Gefahr der Degradation der elektrischen Eigenschaften vermindert ist.

Das Ablösen des Aufwachssubstrats von der Epitaxieschichtenfolge ist für den kantenemittierenden Halbleiterlaser von Vorteil. In diesem Fall können nach dem Ablösen des Aufwachssubstrats Seitenfacetten in der Epitaxieschichtenfolge, welche die Resonatorspiegel des kantenemittierenden Halbleiterlasers ausbilden, auf vergleichsweise einfache Weise durch Ritzen und Spalten der Epitaxieschichtenfolge erzeugt werden. Der Herstellungsaufwand zur Erzeugung der reflektierenden Seitenfacetten ist daher vorteilhaft gering.

Die Erfindung wird im Folgenden anhand des Ausführungsbeispiels der Figur 4 und den in den Figuren 1-3 und 5-12 dargestellten weiteren Beispielen, die jeweils nicht alle Merkmale der Erfindung aufweisen, näher erläutert.

Es zeigen:
Figur 1 eine schematische Darstellung eines Querschnitts durch ein optoelektronisches Bauelement,
Figur 2 eine schematische Darstellung eines Querschnitts durch ein optoelektronisches Bauelement,
Figur 3 eine schematische Darstellung eines Querschnitts durch ein optoelektronisches Bauelement,
Figur 4 eine schematische Darstellung eines Querschnitts durch ein optoelektronisches Bauelement gemäß einem Ausführungsbeispiel der Erfindung,
Figur 5 eine schematische Darstellung eines Querschnitts durch ein optoelektronisches Bauelement,
Figur 6 eine schematische Darstellung eines Querschnitts durch ein optoelektronisches Bauelement,
Figur 7 eine schematische Darstellung eines Querschnitts durch ein optoelektronisches Bauelement,
Figur 8 eine schematische Darstellung eines Querschnitts durch ein optoelektronisches Bauelement,
Figur 9 eine schematische Darstellung eines Beispiels eines Verfahrens anhand von Zwischenschritten,
Figur 10 ein Beispiel eines mit dem Verfahren hergestellten optoelektronischen Bauelements,
Figur 11 ein weiteres Beispiel eines mit dem Verfahren hergestellten optoelektronischen Bauelements, und
Figur 12 ein weiteres Beispiel eines mit dem Verfahren hergestellten optoelektronischen Bauelements.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

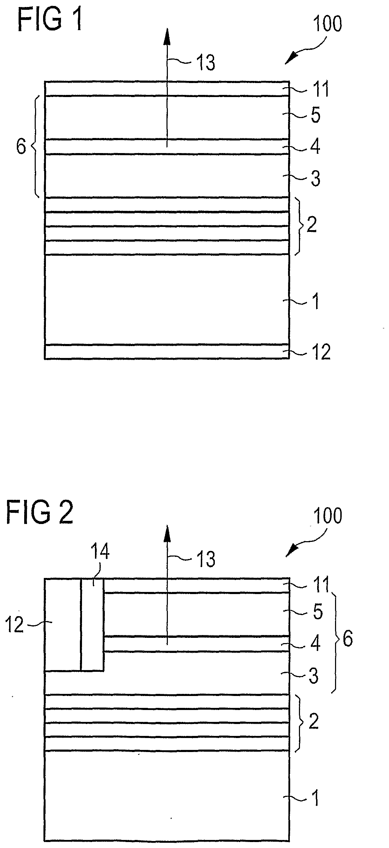

Bei dem in Figur 1 dargestellten Beispiel eines optoelektronischen Bauelements handelt es sich um eine LED 100. Die LED 100 weist ein Aufwachssubstrat 1 aus Al₁₋ₓ(In_{y}Ga_{1-y})ₓN oder In₁₋ₓGaₓN mit 0 < x < 0,99 und 0 ≤ y < 1 auf.

Auf das Aufwachssubstrat 1 sind vorteilhaft mehrere Pufferschichten 2 aufgebracht, die In_{y}AlₓGa_{1-x-y}N aufweisen. Dabei gilt bevorzugt x < 0,9 und y < 0,1.

Auf die Pufferschichten 2 ist eine Epitaxieschichtenfolge 6 aufgebracht. Die Epitaxieschichtenfolge 6 umfasst einen n-dotierten Bereich 3, der eine oder mehrere Halbleiterschichten enthält, und einen p-dotierten Bereich 5, der eine oder mehrere Halbleiterschichten enthält. Zwischen dem n-dotierten Bereich 3 und dem p-dotierten Bereich 5 ist eine aktive Schicht 4 angeordnet.

Die Schichten der Epitaxieschichtenfolge 6, insbesondere die darin enthaltene aktive Schicht 4, basieren auf einem Nitridverbindungshalbleiter.

Die aktive Schicht 4 ist eine Strahlung 13 emittierende Schicht, wobei es sich bei der emittierten Strahlung 13 vorzugsweise um Strahlung aus dem ultravioletten oder aus dem blauen oder grünen sichtbaren Spektralbereich handelt. Bei der aktiven Schicht 4 kann es sich nicht nur um eine Einzelschicht handeln, sondern sie kann auch mehrere Teilschichten umfassen, insbesondere eine Einfach- oder Mehrfach-Quantentopfstruktur.

Zur elektrischen Kontaktierung der LED 100 ist eine p-Kontaktschicht 11 auf die Epitaxieschichtenfolge 6 aufgebracht. Eine n-Kontaktschicht 12 kann beispielsweise auf die Rückseite des Aufwachssubstrats 1 aufgebracht sein.

Das in der LED 100 enthaltene Aufwachssubstrat 1 aus Al₁₋ₓ(In_{y}Ga_{1-y})ₓN oder In₁₋ₓGaₓN mit 0 < x < 0,99 und 0 ≤ y ≤ 1 zeichnet sich vorteilhaft durch eine geringe Defektdichte von vorzugsweise weniger als 1 x 10⁷ cm⁻², besonders bevorzugt von weniger als 1 x 10⁶ cm⁻², aus. Eine gute Gitteranpassung an die Epitaxieschichtenfolge 6 kann durch die zwischen dem Aufwachssubstrat 1 und der Epitaxieschichtenfolge 6 eingefügte Pufferschichtenfolge erzielt werden. Die Zusammensetzungen der Pufferschichten 2 variieren dazu vorzugsweise stufenweise oder in Form eines Gradienten, so dass durch das Aufwachsen der Pufferschichtenfolge 2 möglichst geringe mechanische Verspannungen und damit verbundene Defekte entstehen. Weiterhin hat das Aufwachssubstrat 1 den Vorteil, dass es im Vergleich zu GaN-Substraten vergleichsweise kostengünstig hergestellt werden kann.

Bei der Herstellung der LED 100 wird vorzugsweise vor dem epitaktischen Aufwachsen der Pufferschichtenfolge 2 auf das Aufwachssubstrat 1 eine Temperaturbehandlung des Aufwachssubstrats durchgeführt. Die Temperaturbehandlung kann vorteilhaft in situ, das heißt in der zum epitaktischen Aufwachsen der nachfolgenden Schichten vorgesehenen Beschichtungskammer durchgeführt werden. Die Temperaturbehandlung erfolgt bevorzugt bei einer Temperatur von mehr als 1000 °C, besonders bevorzugt bei einer Temperatur zwischen 1000 °C und 1100 °C. Mittels der Temperaturbehandlung, die bevorzugt unter Zufuhr von H₂-Gas oder NH₃-Gas erfolgt, können vorteilhaft Verunreinigungen wie Oxide oder Kohlenstoffverbindungen von der Substratoberfläche entfernt werden.

Das in Figur 2 dargestellte Beispiel einer LED 100 unterscheidet sich von dem in Figur 1 dargestellten Beispiel dadurch, dass die n-Kontaktschicht 12 nicht an der Rückseite des Aufwachssubstrats 1 angeordnet ist, sondern wie die p-Kontaktschicht 11 an der dem Aufwachssubstrat 1 gegenüberliegenden Seite der LED 100 angeordnet ist. Zur Herstellung des n-Kontakts ist die Epitaxieschichtenfolge 6 vorzugsweise in einem Randbereich der LED 100 bis in den n-dotierten Bereich 3 heruntergeätzt, um den n-dotierten Bereich 3 mit der n-Kontaktschicht 12 zu versehen. Die aktive Schicht 4 und der p-dotierte Bereich 5 sind dabei durch eine elektrisch isolierende Passivierungsschicht 14, die insbesondere auf die frei gelegte Seitenflanke der Epitaxieschichtenfolge 6 aufgebracht ist, von der n-Kontaktschicht 12 isoliert. Diese Art der elektrischen Kontaktierung ist insbesondere dann vorteilhaft, wenn das Aufwachssubstrat 1 nicht elektrisch leitend ist. Eine alternative Möglichkeit zur elektrischen Kontaktierung der LED 100 im Fall eines elektrisch nicht leitenden Aufwachssubstrats besteht darin, dass Durchkontaktierungen von der Rückseite des Aufwachssubstrats 1 durch das Aufwachssubstrat 1 hindurch zu dem mindestens einen n-dotierten Bereich 3 hin geführt sind (nicht dargestellt).

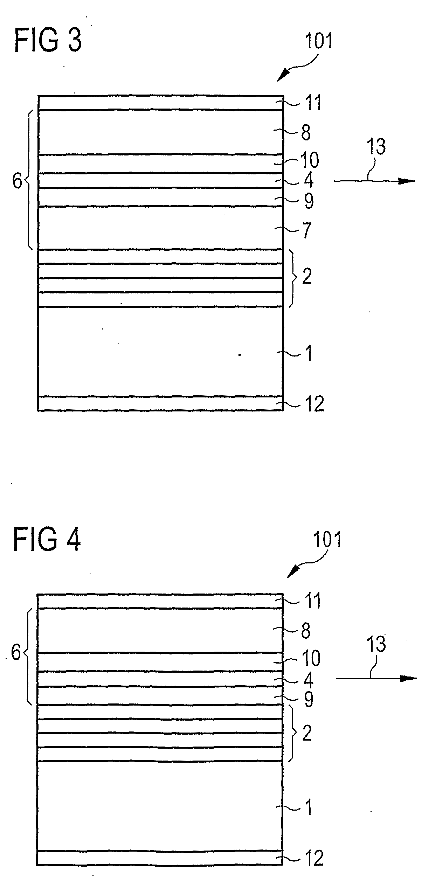

Bei dem in Figur 3 dargestellten Beispiel eines optoelektronischen Bauelements handelt es sich um einen kantenemittierenden Halbleiterlaser 101. Wie die LEDs der vorherigen Beispiele ist der kantenemittierende Halbleiterlaser 101 auf ein Aufwachssubstrat 1 aus Al₁₋ₓ (In_{y}Ga_{1-y})ₓN oder In₁₋ₓGaₓN mit 0 < x < 0, 99 und 0 ≤ y ≤ 1 aufgewachsen. Zwischen dem Aufwachssubstrat 1 und der Epitaxieschichtenfolge 6 des kantenemittierenden Halbleiterlasers 101 sind mehrere Pufferschichten 2, die vorzugsweise mehrere Schichten aus In_{y}AlₓGa_{1-x-y}N mit x < 0,9 und y < 0,1 umfassen, angeordnet. Die elektrische Kontaktierung des kantenemittierenden Halbleiterlasers erfolgt beispielsweise mittels einer auf die Epitaxieschichtenfolge 6 aufgebrachten p-Kontaktschicht 11 und einer an der Rückseite des Aufwachssubstrats 1 angeordneten n-Kontaktschicht 12.

Die Epitaxieschichtenfolge 6 des kantenemittierenden Halbleiterlasers enthält eine aktive Schicht 4, die zwischen einer ersten Wellenleiterschicht 9 und einer zweiten Wellenleiterschicht 10 angeordnet ist. An den von der aktiven Schicht 4 abgewandten Seiten grenzen an die erste Wellenleiterschicht 9 eine erste Mantelschicht 7 und an die zweite Wellenleiterschicht 10 eine zweite Mantelschicht 8 an.

Vorzugsweise sind die dem Aufwachssubstrat 1 zugewandte erste Mantelschicht 7 und die erste Wellenleiterschicht 9 n-dotiert und die vom Aufwachssubstrat 1 aus gesehen oberhalb der aktiven Schicht 4 angeordnete erste Wellenleiterschicht 10 und zweite Mantelschicht 8 p-dotiert. Die Mantelschichten 7, 8 zeichnen sich durch einen geringeren Brechungsindex als die Wellenleiterschichten 9, 10 aus, und bewirken so, dass die Laserstrahlung 13, die sich in lateraler Richtung ausbreitet, in den Wellenleiterschichten 9, 10 geführt wird.
Das Aufwachssubstrat 1 hat den Vorteil einer geringen Defektdichte, wodurch sich insbesondere die Langzeitstabilität des kantenemittierenden Halbleiterlasers 101 verbessert. Weiterhin sind die Herstellungskosten im Gegensatz zur Verwendung eines GaN-Aufwachssubstrats vergleichsweise gering.
In Figur 4 ist ein Ausführungsbeispiel eines kantenemittierenden Halbleiterlasers 101 gemäß der Erfindung dargestellt. Dieses Ausführungsbeispiel unterscheidet sich von dem in Figur 3 dargestellten Beispiel dadurch, dass die Epitaxieschichtenfolge 6 keine dem Aufwachssubstrat 1 zugewandte erste Mantelschicht enthält. Bei diesem Ausführungsbeispiel ist die erste Wellenleiterschicht 9 also direkt auf die Pufferschichtenfolge 2 aufgebracht und nur die vom Aufwachssubstrat aus gesehen oberhalb der aktiven Schicht 4 angeordnete zweite Wellenleiterschicht 10 grenzt an eine zweite Mantelschicht 8 an. Auf die erste Mantelschicht kann vorteilhaft verzichtet werden, wenn das Aufwachssubstrat 1 aus Al₁₋ₓ(In_{y}Ga_{1-y})ₓN oder In₁₋ₓGaₓN mit 0 < x < 0,99 und 0 ≤ y ≤ 1 und/oder die Pufferschichtenfolge 2, die vorteilhaft mehrere Schichten aus In_{y}AlₓGa_{1-x-y}N mit x < 0, 9 und y < 0,1 enthält, aufgrund ihres Aluminiumanteils einen vergleichsweise geringen Brechungsindex aufweisen, der bereits zur optischen Führung der Laserstrahlung in dem aus der aktiven Schicht 4, der ersten Wellenleiterschicht 9 und der zweiten Wellenleiterschicht 10 gebildeten Wellenleiter ausreicht. Durch den Verzicht auf die dem Aufwachssubstrat 1 zugewandte Mantelschicht verringert sich der Herstellungsaufwand vorteilhaft. Weiterhin reduziert sich die Schichtdicke der Epitaxieschichtenfolge 6, wodurch sich auch die Wärmeabfuhr der von der aktiven Schicht 4 erzeugten Wärme zum Aufwachssubstrat 1 verbessert.

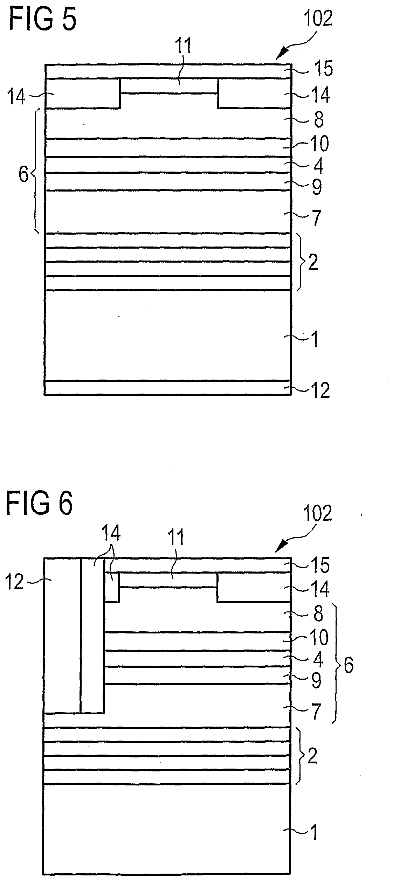

Bei dem in Figur 5 dargestellten Beispiel eines optoelektronischen Bauelements handelt es sich um einen Rippenwellenleiter-Laser 102. Die Schichtenfolge des Rippenwellenleiter-Lasers 102 entspricht im Wesentlichen dem in Figur 3 dargestellten Beispiel eines kantenemittierenden Halbleiterlasers. Der Rippenwellenleiter-Laser 102 unterscheidet sich von dem in Figur 3 dargestellten kantenemittierenden Halbleiterlaser dadurch, dass in der oberen Mantelschicht 8 und der p-Kontaktschicht 11 ein Steg zur Ausbildung eines Rippenwellenleiters erzeugt ist. Die Herstellung des Steges kann beispielsweise mittels eines Ätzprozesses erfolgen, bei dem Teile der p-Kontaktschicht 11 und der Mantelschicht 8 entfernt werden, so dass nur ein streifenförmiger Bereich übrig bleibt. Die freigelegten Bereiche der Mantelschicht 8 und der p-Kontaktschicht 11 sind jeweils mit Passivierungsschichten 14 versehen. Auf die p-Kontaktschicht 11 kann eine Kontaktmetallisierung 15 aufgebracht sein, wobei die außerhalb des zentralen Steges angeordneten Bereiche der Mantelschicht 8 durch die Passivierungsschichten 14 von der Kontaktmetallisierung 15 isoliert sind. Durch diese Art der Strukturierung und Kontaktierung wird die Laseremission in der aktiven Schicht 4 auf einen zentralen streifenförmigen Bereich eingeschränkt.

Die n-seitige Kontaktierung des Rippenwellenleiter-Lasers 102 erfolgt beispielsweise durch eine n-Kontaktschicht 12, die an der von der aktiven Schicht 4 abgewandten Rückseite des Aufwachssubstrats 1 angeordnet sein kann. Im Falle eines nicht leitenden Aufwachssubstrats 1 kann die Kontaktschicht 12 auch als Durchkontaktierung durch das Aufwachssubstrat bis zu den n-dotierten Schichten, beispielsweise den Pufferschichten 2, geführt sein.

Figur 6 zeigt ein weiteres Beispiel eines Rippenwellenleiter-Lasers 102, das sich von dem in Figur 5 dargestellten Beispiel durch die Art der Herstellung des n-Kontakts. Bei dem in Figur 6 dargestellten Rippenwellenleiter-Laser 102 erfolgt die Kontaktierung ähnlich wie bei der in Figur 2 dargestellten LED. Die Epitaxieschichtenfolge 6 ist in einem Randbereich des Rippenwellenleiter-Lasers 102 bis in den Bereich der n-dotierten Halbleiterschichten 7, 9 heruntergeätzt, so dass diese mit einer n-Kontaktschicht 12 kontaktiert werden können. Die aktive Schicht 4 und die p-dotierten Halbleiterschichten 10, 8 sind dabei mittels einer Passivierungsschicht 14 elektrisch von der n-Kontaktschicht 12 isoliert. Diese Art der elektrischen Kontaktierung ist insbesondere dann von Vorteil, wenn das Aufwachssubstrat 1 elektrisch nicht leitend ist.

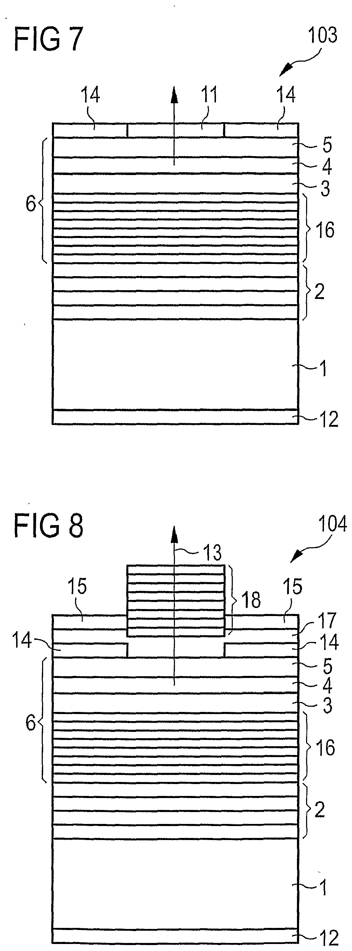

Bei dem in Figur 7 dargestellten Beispiel eines optoelektronischen Bauelements handelt es sich um eine LED mit resonanter Kavität (RCLED) 103. Die RCLED 103 weist wie die zuvor beschriebenen Beispiele ein Aufwachssubstrat aus Al₁₋ₓ(In_{y}Ga_{1-y})ₓN oder In₁₋ₓGaₓN mit 0 < x < 0,99 und 0 ≤ y ≤ 1 auf. Auf das Aufwachssubstrat 1 sind mehrere Pufferschichten 2 aus In_{y}AlₓGa_{1-x-y}N mit x < 0,9 und y < 0,1 aufgebracht. Auf die Pufferschichten 2 ist eine Epitaxieschichtenfolge 6 aufgebracht, die einen DBR-Spiegel 16 enthält. Der DBR-Spiegel 16 enthält eine Vielzahl von Schichtpaaren aus ersten Schichten und zweiten Schichten, die sich in ihrer Materialzusammensetzung und somit in ihrem Brechungsindex voneinander unterscheiden.

Vorzugsweise enthalten die Schichtpaare erste Schichten aus In_{y1}Alₓ₁Ga_{1-x1-y1} und zweite Schichten aus In_{y2}Alₓ₂Ga_{1-x2-y2}, wobei für den Aluminiumgehalt vorteilhaft x1 > 0,01 und x2 > 0,05 mit x1 ≠ x2 gilt. Dadurch, dass die Schichtpaare des DBR-Spiegels 16 mit einem vergleichsweise hohen Aluminiumgehalt auf dem Aufwachssubstrat 1 und der darauf aufgebrachten Pufferschichtenfolge 2 aufgewachsen werden können, ist es möglich, einen höheren Brechungsindexkontrast zwischen den ersten und zweiten Schichten des DBR-Spiegels 16 zu erzielen, so dass die Anzahl der Schichtpaare im Vergleich zu einem herkömmlichen DBR-Spiegel mit gleicher Reflektivität verringert werden kann. Auf diese Weise verringert sich vorteilhaft die Schichtdicke der Epitaxieschichtenfolge 6, was sich positiv auf die Wärmeabfuhr der von der aktiven Schicht 4 erzeugten Wärme auswirkt.

Vorteilhaft für die Wärmeableitung der von der aktiven Schicht 4 erzeugten Wärme ist weiterhin, dass das Aufwachssubstrat aus Al₁₋ₓ(In_{y}Ga_{1-y})ₓN oder In₁₋ₓGaₓN mit 0 < x < 0,99 und 0 ≤ y ≤ 1 im Vergleich zu herkömmlich zum Aufwachsen von Nitridverbindungshalbleitern verwendeten Substraten wie Saphir oder GaN eine vergleichsweise gute Wärmeleitfähigkeit aufweist.

Die Halbleiterschichten des DBR-Spiegels 16 sind bevorzugt n-dotiert. Auf den DBR-Spiegel 16 folgen mindestens ein Bereich n-dotierter Halbleiterschichten 3, die aktive Schicht 4 und mindestens ein Bereich p-dotierter Halbleiterschichten 5. Auf den p-dotierten Bereich 5 ist eine p-Kontaktschicht 11 aufgebracht, die einen Teil der von der aktiven Schicht 4 emittierten Strahlung 13 zurückreflektiert und somit mit dem DBR-Spiegel 16 eine Kavität ausbildet. Auf diese Weise wird erreicht, dass die RCLED 103 Strahlung 13 mit hoher Intensität in eine Vorzugsrichtung senkrecht zur aktiven Schicht 4 emittiert. Um einen geringen Strahlquerschnitt zu erzielen, ist die teilweise reflektierende p-Kontaktschicht 12 nur auf einen zentralen Teilbereich des p-dotierten Bereichs 5 aufgebracht, wobei die seitlich angrenzenden Bereiche vorzugsweise mit einer Passivierungsschicht 14 versehen sind.

Die anhand des in Figur 7 dargestellten Beispiels beschriebenen Vorteile des Aufwachssubstrats 1 und des darauf aufgebrachten DBR-Spiegels 16 treffen auch auf das in Figur 8 dargestellte optoelektronische Bauelement zu, bei dem es sich um einen oberflächenemittierenden Halbleiterlaser mit Vertikalresonator (VCSEL) 104 handelt. Bei dem oberflächenemittierenden Halbleiterlaser 104 bildet der DBR-Spiegel 16 den ersten Resonatorspiegel für die Laserstrahlung 13. Der zweite Resonatorspiegel des oberflächenemittierenden Halbleiterlasers wird durch einen von der aktiven Schicht 4 aus gesehen dem ersten DBR-Spiegel 16 gegenüberliegenden zweiten DBR-Spiegel 18 ausgebildet. Im Gegensatz zum ersten DBR-Spiegel 16, der vorzugsweise aus alternierenden n-dotierten Halbleiterschichten gebildet ist, wird der zweite DBR-Spiegel 18 durch alternierende dielektrische Schichten gebildet. Der zweite DBR-Spiegel 18 ist auf eine transparente Kontaktschicht 17 aufgebracht, die zur elektrischen Kontaktierung des oberflächenemittierenden Halbleiterlasers 104 dient. Die transparente Kontaktschicht 17 grenzt in einem zentralen Bereich des oberflächenemittierenden Halbleiterlasers 104 an den p-dotierten Bereich 5 an. Um den Stromfluss und somit auch die Erzeugung von Laserstrahlung 13 auf einen zentralen Bereich des oberflächenemittierenden Halbleiterlasers 104 zu beschränken, ist die transparente Kontaktschicht 17 in den Randbereichen des oberflächenemittierenden Halbleiterlasers durch Passivierungsschichten 14 von der Epitaxieschichtenfolge isoliert. Seitlich des DBR-Spiegels 18 kann die transparente Kontaktschicht mit Kontaktmetallisierungen 15 versehen sein. Die Auskopplung der von dem oberflächenemittierenden Halbleiterlaser 104 erzeugten Strahlung 13 erfolgt durch den zweiten DBR-Spiegel 18. Die elektrische Kontaktierung des oberflächenemittierenden Halbleiterlasers 104 erfolgt zum einen durch die transparente Kontaktschicht 17 in Verbindung mit den Kontaktmetallisierungen 15 und zum anderen beispielsweise durch eine auf die Rückseite des Aufwachssubstrats aufgebrachte n-Kontaktschicht 12. Alternativ kann die elektrische Kontaktierung der n-dotierten Seite des oberflächenemittierenden Halbleiterlasers 104 auch wie bei dem in Figur 6 dargestellten Rippenwellenleiter-Laser erfolgen. Die n-Kontaktschicht 12 kann im Falle eines nichtleitenden Aufwachssubstrats 1 alternativ auch mittels Durchkontaktierungen durch das Aufwachssubstrat 1 elektrisch leitend mit den n-dotierten Halbleiterschichten des oberflächenemittierenden Halbleiterlasers 104 verbunden sein.

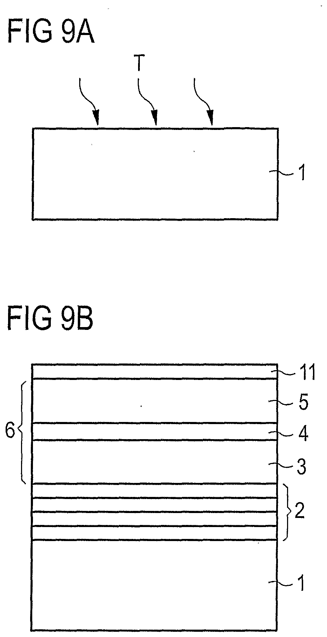

In den Figuren 9a bis 9e wird ein Beispiel eines Verfahrens anhand von Zwischenschritten näher erläutert.

Bei dem in Figur 9a dargestellten Zwischenschritt wird ein Aufwachssubstrat aus Al₁₋ₓ(In_{y}Ga_{1-y})ₓN oder In₁₋ₓGaₓN mit 0 < x < 0,99 und 0 ≤ y ≤ 1 bereitgestellt, auf das die Epitaxieschichtenfolge eines optoelektronischen Bauelements aufgewachsen werden soll. Das Aufwachssubstrat 1 wird vorteilhaft in situ, das heißt in der zum Aufwachsen der Epitaxieschichtenfolge vorgesehenen Beschichtungskammer, einer Temperaturbehandlung bei einer Temperatur T von vorzugsweise mehr als 1000 °C, beispielsweise zwischen 1000 °C und 1100 °C, unterzogen. Die Temperaturbehandlung findet vorzugsweise unter Zufuhr von H₂ oder NH₃-Gas statt und dient dazu, Kohlenstoff und/oder Sauerstoff enthaltende Verunreinigungen von der Oberfläche des Aufwachssubstrats 1 zu entfernen.

Bei dem in Figur 9b dargestellten Zwischenschritt ist eine Halbleiterschichtenfolge auf das so vorbehandelte Aufwachssubstrat 1 aufgewachsen worden. Unmittelbar auf das Aufwachssubstrat 1 ist eine Pufferschichtenfolge 2, die mehrere Schichten aus In_{y}Al₁₋ₓGaₓN mit x < 0,9 und y < 0,1 enthält, aufgewachsen worden. Auf die Pufferschichten 2 ist eine Epitaxieschichtenfolge 6 des optoelektronischen Bauelements aufgewachsen, die mindestens eine n-dotierte Halbleiterschicht 3, die aktive Schicht 4 und mindestens eine p-dotierte Halbleiterschicht 5 enthält. Auf die mindestens eine p-dotierte Halbleiterschicht 5 ist eine p-Kontaktschicht 11 aufgebracht. Die Epitaxieschichtenfolge 6 entspricht somit dem in Figur 1 dargestellten Beispiel einer LED.

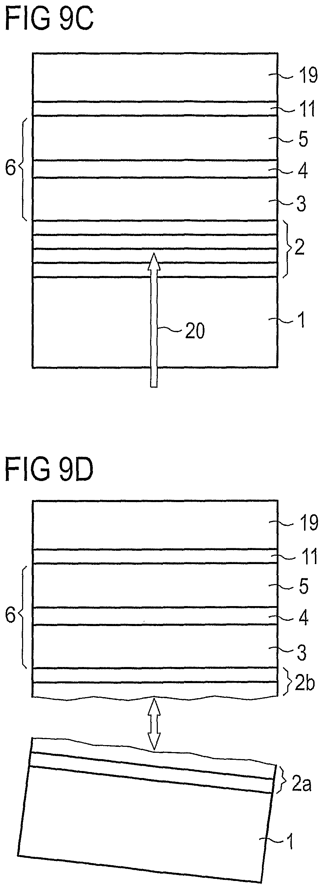

Bei dem in Figur 9c dargestellten Zwischenschritt des Verfahrens ist auf die p-Kontaktschicht 11 ein Träger 19 aufgebracht worden. Der Träger 19 ist vorzugsweise elektrisch leitend, so dass vorteilhaft ein elektrischer Kontakt für das mit dem Verfahren hergestellte optoelektronische Bauelement über den Träger 19 realisiert werden kann.

Nachfolgend wird das Aufwachssubstrat 1 durch ein Laser-Lift-Off-Verfahren abgelöst. Dabei wird Laserstrahlung 20 durch das Aufwachssubstrat 1 hindurch in die zuvor aufgebrachten Halbleiterschichten eingestrahlt. Dabei wird ausgenutzt, dass das Aufwachssubstrat 1 aus Al₁₋ₓ(In_{y}Ga_{1-y})ₓN oder In₁₋ₓGaₓN mit 0 < x < 0,99 und 0 ≤ y ≤ 1 vorteilhaft für Laserstrahlung transparent ist, die von den Halbleiterschichten absorbiert wird. Die Laserstrahlung 20 wird vorzugsweise im Bereich der Pufferschichtenfolge 2 absorbiert, wobei die Absorption der Laserstrahlung 20 dazu führt, dass das Halbleitermaterial derart zersetzt wird, dass der Halbleiterkörper in diesem Bereich durchtrennt wird, wie es in Figur 9d schematisch dargestellt ist. Nach dem Durchtrennen des Halbleiterkörpers mittels des Laser-Lift-Off-Verfahrens liegen also das Aufwachssubstrat 1, gegebenenfalls mit Resten der Pufferschichtenfolge 2a, und die Epitaxieschichtenfolge 6 auf dem Träger 19 separiert voneinander vor.

Die auf den zertrennten Hälften des Halbleiterkörpers verbleibenden Reste der Pufferschichtenfolge 2a, 2b können beispielsweise mittels eines Ätzverfahrens von dem Aufwachssubstrat 1 oder der Epitaxieschichtenfolge 6 entfernt werden. Dies hat insbesondere den Vorteil, dass das Aufwachssubstrat 1 zum Aufwachsen weiterer Halbleiterschichtenfolgen wiederverwertet werden kann.

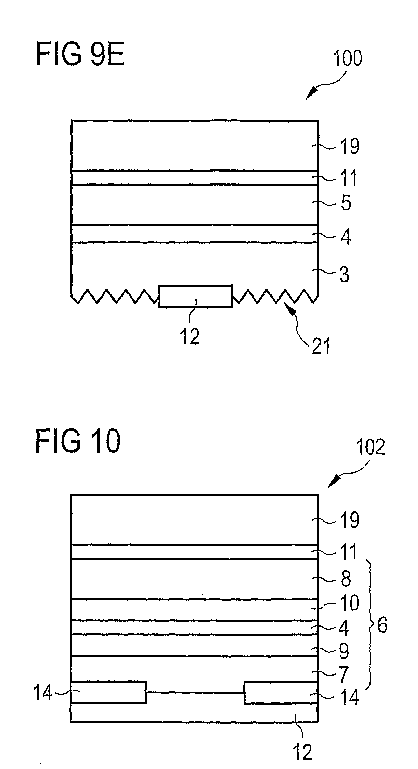

Mit dem Teil des separierten Halbleiterkörpers, der den Träger 19 und die Epitaxieschichtenfolge 6 enthält, wird in den folgenden Verfahrensschritten das optoelektronische Bauelement fertig gestellt. Vorzugsweise wird, wie in Figur 9e dargestellt ist, die von den Resten der Pufferschichtenfolge befreite n-dotierte Bereich 3 der Epitaxieschichtenfolge 6 mit einer Strukturierung 21 versehen, durch die die Strahlungsauskopplung aus dem optoelektronischen Bauelement verbessert wird. Beispielsweise kann die dem Träger 19 gegenüberliegende Oberfläche des n-dotierten Bereichs 3, durch die bei dem optoelektronischen Bauelement die Strahlung ausgekoppelt wird, derart aufgeraut werden, dass der Anteil der von der aktiven Schicht 4 emittierten Strahlung, der an der Grenzfläche zwischen dem n-dotierten Bereich 3 und dem Umgebungsmedium totalreflektiert wird, vermindert wird.

Weiterhin wird zumindest ein Teilbereich der Oberfläche des n-dotierten Bereichs 3 mit einer n-Kontaktschicht 12 versehen, um das optoelektronische Bauelement, bei dem es sich um eine LED 100 handelt, fertig zu stellen.

In den Figuren 10, 11 und 12 sind drei weitere Beispiele von optoelektronischen Bauelementen dargestellt, die mit dem Verfahren hergestellt sind. Diesen Beispielen ist gemeinsam, dass die in diesem optoelektronischen Bauelementen enthaltene Epitaxieschichtenfolge jeweils auf einem Aufwachssubstrat aus Al₁₋ₓ(In_{y}Ga_{1-y})ₓN oder In₁₋ₓGaₓN mit 0 < x < 0,99 und 0 ≤ y ≤ 1 aufgewachsen wurde, das nach dem Verbinden der Epitaxieschichtenfolge auf der dem Aufwachssubstrat gegenüber liegenden Seite mit einem Träger von der Epitaxieschichtenfolge abgelöst wurde. Diese Verfahrensschritte entsprechen den in Zusammenhang mit den Figuren 9a bis 9d erläuterten Verfahrensschritten und werden daher im Folgenden nicht näher erläutert.

Die in den Figuren 10, 11 und 12 dargestellten optoelektronischen Bauelemente unterscheiden sich aber in der Art der Epitaxieschichtenfolge 6 von dem in Figur 9e dargestellten Beispiel und in der Art der Strukturierung der durch das Ablösen des Aufwachssubstrats zugänglich gewordenen n-dotierten Halbleiterschichten. Diese Unterschiede zu der in Figur 9e dargestellten LED 100 werden im Folgenden näher erläutert.

Bei dem in Figur 10 dargestellten optoelektronischen Bauelement handelt es sich um einen Rippenwellenleiter-Laser 102. Die Epitaxieschichtenfolge 6 des Rippenwellenleiter-Lasers 102 entspricht im wesentlichen dem in Figur 5 dargestellten Beispiel, das heißt sie enthält eine n-dotierte erste Mantelschicht 7, eine n-dotierte erste Wellenleiterschicht 9, die aktive Schicht 4, eine zweite p-dotierte Wellenleiterschicht 10 und eine zweite p-dotierte Mantelschicht 8. Im Gegensatz zu dem in Figur 5 dargestellten Beispiel ist der Rippenwellenleiter des Rippenwellenleiter-Lasers 102 nicht in der p-dotierten Mantelschicht 8, sondern in der n-dotierten Mantelschicht 7, die nach dem Ablösen des Aufwachssubstrats einer Strukturierung zugänglich ist, erzeugt worden. Die n-dotierte Mantelschicht 7 ist beispielsweise durch einen Ätzprozeß zu einem Rippenwellenleiter strukturiert worden, wobei die seitlich an den Rippenwellenleiter angrenzenden Bereiche jeweils mit Passivierungsschichten 14 versehen sind. Auf den mit den Passivierungsschichten 14 versehenen Rippenwellenleiter ist eine n-Kontaktschicht 12 aufgebracht. Die p-seitige Kontaktierung des Steifenlasers 102 erfolgt über eine p-Kontaktschicht 11, die auf die p-dotierte Mantelschicht 8 aufgebracht ist. An der p-Kontaktschicht 11 ist der elektrisch leitfähige Träger 19 angeordnet.

Das Erzeugen des Rippenwellenleiters in der n-dotierten Mantelschicht 7 hat den Vorteil, dass die Gefahr einer Degradation der elektrischen Eigenschaften vermindert ist, da sich herausgestellt hat, dass n-dotierte Schichten im Vergleich p-dotierten Schichten hinsichtlich ihrer elektrischen Eigenschaften weniger empfindlich gegenüber Ätzprozessen, insbesondere Plasmaätzprozessen, sind.

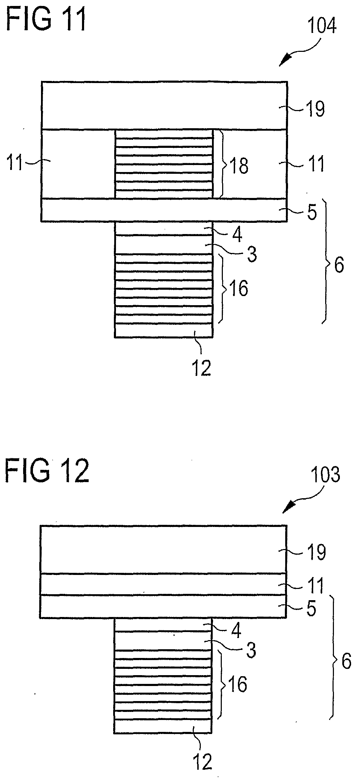

Figur 11 zeigt ein Beispiel eines optoelektronischen Bauelements in Form eines oberflächenemittierenden Halbleiterlasers 104 mit Vertikalresonator (VCSEL), bei dem die Epitaxieschichtenfolge 6 auf einem Aufwachssubstrat aus Al₁₋ₓ(In_{y}Ga_{1-y})ₓN oder In₁₋ₓGaₓN mit 0 < x < 0,99 und 0 ≤ y ≤ 1 aufgewachsen wurde, dass von der Epitaxieschichtenfolge 6 abgelöst wurde, so dass der Bereich der n-dotierten Halbleiterschichten einer Strukturierung zugänglich ist.

Die Epitaxieschichtenfolge 6 des oberflächenemittierenden Halbleiterlasers 104 weist mindestens einen p-dotierten Bereich 5, die aktive Schicht 4, einen n-dotierten Bereich 3 und einen n-dotierten DBR-Spiegel 16 auf. Die n-dotierten Halbleiterschichten 3, 16 und die aktive Schicht 4 sind zu einer Mesa strukturiert worden. Auf den unstrukturierten p-dotierten Bereich 5 ist auf der von der aktiven Schicht 4 abgewandten Seite ein DBR-Spiegel 18 aufgebracht, der vorzugsweise aus dielektrischen Schichten gebildet ist. Der n-dotierte DBR-Spiegel 16 und der dielektrische DBR-Spiegel 18 bilden den Laserresonator des oberflächenemittierenden Halbleiterlasers 104 aus.

Der DBR-Spiegel 18 ist vorzugsweise so strukturiert, dass er die gleiche Ausdehnung aufweist wie die durch die aktive Schicht 4, den n-dotierten Bereich 3 und den DBR-Spiegel 16 gebildete Mesa. Der dielektrische DBR-Spiegel 18 wird beispielsweise vor dem Ablösen des Aufwachssubstrats strukturiert, bevor der Halbleiterkörper mit dem Träger 19 verbunden wird. Die elektrische Kontaktierung des oberflächenemittierenden Halbleiterlasers 104 erfolgt über p-Kontaktschichten 11, die seitlich des DBR-Spiegels 18 angeordnet sind und an den p-dotierten Bereich 5 angrenzen. Eine n-Kontaktschicht 12 ist auf den DBR-Spiegel 16 aufgebracht. Die n-Kontaktschicht 12 ist vorzugsweise eine transparente Kontaktschicht, insbesondere aus einem elektrisch leitfähigen transparenten Oxid wie beispielsweise ITO oder ZnO, oder sie weist eine vorzugsweise kreisförmige Öffnung zur Auskopplung der von dem oberflächenemittierenden Halbleiterlaser 104 emittierten Strahlung auf. Der Träger 19 ist an dem DBR-Spiegel 18 und den seitlich davon angeordneten p-Kontaktschichten 11 angeordnet.

Bei dem in Figur 12 dargestellten optoelektronischen Bauelement handelt es sich um eine LED mit resonanter Kavität (RCLED) 103. Die RCLED 103 weist wie der in Figur 11 dargestellte VCSEL eine Mesa-Struktur auf, die die aktive Schicht 4, einen n-dotierten Bereich 3 und einen n-dotierten DBR-Spiegel 16 aufweist. Ebenfalls weist die RCLED 103 mindestens einen p-dotierten Bereich 5 auf. Im Gegensatz zu dem im vorherigen Beispiel beschriebenen VCSEL weist die RCLED 103 auf dem p-dotierten Bereich 5 nicht einen weiteren DBR-Spiegel, sondern lediglich eine teilweise reflektierende p-Kontaktschicht 11 aufweist. An der reflektierenden p-Kontaktschicht 11 ist die RCLED 103 mit einem leitfähigen Träger 19 verbunden. Ein zweiter elektrischer Kontakt der RCLED 103 ist dadurch realisiert, dass auf den n-dotierten DBR-Spiegel 16 eine n-Kontaktschicht 12 aufgebracht ist.

## Patentansprüche

1. Kantenemittierender Halbleiterlaser, der eine auf einem Nitridverbindungshalbleiter basierende Epitaxieschichtenfolge (6) mit einer aktiven Schicht (4) aufweist, und bei dem auf einem Aufwachssubstrat (1) mehrere Pufferschichten (2) aus In_{y}AlₓGa_{1-x-y}N mit x < 0,9 und y < 0,1 aufgebracht sind, wobei die aktive Schicht (4) des kantenemittierenden Halbleiterlasers (101) zwischen zwei Wellenleiterschichten (9, 10) angeordnet ist, und wobei der von der aktiven Schicht (4) aus gesehen dem Aufwachssubstrat (1) gegenüberliegenden Wellenleiterschicht (10) eine Mantelschicht (8) nachfolgt,
**dadurch gekennzeichnet, dass**
das Aufwachssubstrat (1) Al₁₋ₓ(In_{y}Ga_{1-y})ₓN oder In₁₋ₓGaₓN mit 0 < x < 0,99 und 0 ≤ y ≤ 1 aufweist, und das Aufwachssubstrat und/oder die Pufferschichten einen Aluminiumgehalt aufweisen,
wobei zwischen dem Aufwachssubstrat (1) und der dem Aufwachssubstrat (1) zugewandten Wellenleiterschicht (9) keine Mantelschicht angeordnet ist.

2. Kantenemittierender Halbleiterlaser nach Anspruch 1,
**dadurch gekennzeichnet, dass**
das Aufwachssubstrat (1) eine Defektdichte von weniger als 10⁷ cm⁻² aufweist.

3. Verfahren zur Herstellung eines kantenemittierenden Halbleiterlasers, umfassend die Verfahrensschritte:
- Bereitstellen eines Aufwachssubstrats (1) aus Al₁₋ₓ(In_{y}Ga_{1-y})ₓN oder In₁₋ₓGaₓN mit 0 < x < 0,99 und 0 ≤ y ≤ 1, und
- Aufwachsen einer auf einem Nitridverbindungshalbleiter basierenden Epitaxieschichtenfolge (6), die eine aktive Schicht (4) aufweist,
wobei vor dem Aufwachsen der Epitaxieschichtenfolge (6) mehrere Pufferschichten (2) aus In_{y}AlₓGa_{1-x-y}N mit x < 0,9 und y < 0,1 auf das Aufwachssubstrat (1) aufgewachsen werden, und das Aufwachssubstrat und/oder die Pufferschichten einen Aluminiumgehalt aufweisen, und die aktive Schicht (4) des kantenemittierenden Halbleiterlasers (101) zwischen zwei Wellenleiterschichten (9, 10) angeordnet ist, wobei der von der aktiven Schicht (4) aus gesehen dem Aufwachssubstrat (1) gegenüberliegenden Wellenleiterschicht (10) eine Mantelschicht (8) nachfolgt und zwischen dem Aufwachssubstrat (1) und der dem Aufwachssubstrat (1) zugewandten Wellenleiterschicht (9) keine Mantelschicht angeordnet ist.

4. Verfahren nach Anspruch 3,
**dadurch gekennzeichnet, dass**
durch Ritzen und Spalten der Epitaxieschichtenfolge (6) Seitenfacetten für einen kantenemittierenden Halbleiterlaser (101) in der Epitaxieschichtenfolge (6) erzeugt werden.

## Claims

1. Edge-emitting semiconductor laser which comprises an epitaxial layer sequence (6) having an active layer (4) and based on a nitride compound semiconductor, and in which several buffer layers (2) consisting of In_{y}AlₓGa_{1-x-y}N, where x < 0.9 and y < 0.1, are applied on a growth substrate (1), wherein the active layer (4) of the edge-emitting semiconductor laser (101) is disposed between two waveguide layers (9, 10), and wherein the waveguide layer (10) which as seen from the active layer (4) is opposite the growth substrate (1) is followed by a cladding layer (8), **characterised in that** the growth substrate (1) comprises Al₁₋ₓ(In_{y}Ga_{1-y})ₓN or In₁₋ₓGaₓN, where 0 < x < 0.99 and 0 ≤ y ≤ 1,
and the growth substrate and/or the buffer layers comprise an aluminium content,
wherein no cladding layer is disposed between the growth substrate (1) and the waveguide layer (9) facing towards the growth substrate (1).

2. Edge-emitting semiconductor laser according to claim 1 1, **characterised in that**
the growth substrate (1) comprises a defect density of less than 10⁷ cm⁻².

3. Method for producing an edge-emitting semiconductor laser, comprising the method steps of:
- providing a growth substrate (1) composed of Al₁₋ₓ(In_{y}Ga_{1-y})ₓN or In₁₋ₓGaₓN, where 0 < x < 0.99 and 0 ≤ y ≤ 1, and
- growing an epitaxial layer sequence (6) based on a nitride compound semiconductor and comprising an active layer (4),
wherein several buffer layers (2) composed of In_{y}AlₓGa_{1-x-y}N, where x < 0.9 and y < 0.1, are grown onto the growth substrate (1) prior to growth of the epitaxial layer sequence (6),
the growth substrate and/or the buffer layers comprise an aluminium content, and
the active layer (4) of the edge-emitting semiconductor laser (101) is disposed between two waveguide layers (9, 10), wherein the waveguide layer (10) which as seen from the active layer (4) is opposite the growth substrate (1) is followed by a cladding layer (8) and no cladding layer is disposed between the growth substrate (1) and the waveguide layer (9) facing towards the growth substrate (1).

4. Method according to claim 3,
**characterised in that** side facets for an edge-emitting semiconductor laser (101) are produced in the epitaxial layer sequence (6) by scribing and cleaving the epitaxial layer sequence (6).

## Revendications

1. Laser à semi-conducteur à émission latérale, qui présente une succession de couches épitaxiales (6) avec une couche active (4) basée sur semi-conducteur à base de composé de nitrure, et dans lequel plusieurs couches tampons (2) en In_{y}AlₓGa_{1-x-y}N avec x < 0,9 et y < 0,1 sont placées sur un substrat d'épitaxie (1), dans lequel la couche active (4) du laser à semi-conducteur à émission latérale (101) est disposée entre deux couches guide d'ondes (9, 10), et dans lequel la couche guide d'ondes (10) opposée au substrat d'épitaxie (1) vu au départ de la couche active (4) est suivie par une couche de revêtement (8), **caractérisé en ce que**
le substrat d'épitaxie (1) présente Al₁₋ₓ(In_{y}Ga_{1-y})ₓN ou In₁₋ₓGaₓN avec 0 < x < 0,99 et 0 ≤ y ≤ 1,
et le substrat d'épitaxie et/ou les couches tampons présentent une teneur en aluminium,
dans lequel aucune couche de revêtement n'est disposée entre le substrat d'épitaxie (1) et la couche guide d'ondes (9) dirigée vers le substrat d'épitaxie (1).

2. Laser à semi-conducteur à émission latérale selon la revendication 1, **caractérisé en ce**
**que** le substrat d'épitaxie (1) présente une densité de défauts inférieure à 10⁷ cm⁻².

3. Procédé de fabrication d'un laser à semi-conducteur à émission latérale, comprenant les étapes :
- de préparation d'un substrat d'épitaxie (1) en Al₁₋ₓ(In_{y}Ga_{1-y})ₓN ou In₁₋ₓGaₓN avec 0 < x < 0,99 et 0 ≤ y ≤ 1, et
- d'épitaxie d'une succession de couches épitaxiales (6) basée sur semi-conducteur à base de composé de nitrure, laquelle présente une couche active (4),
dans lequel avant l'épitaxie de la succession de couches épitaxiales (6) plusieurs couches tampons (2) en In_{y}AlₓGa_{1-x-y}N avec x < 0,9 et y < 0,1 sont épitaxiées sur le substrat d'épitaxie (1),
le substrat d'épitaxie et/ou les couches tampons présentent une teneur en aluminium et
la couche active (4) du laser à semi-conducteur à émission latérale (101) est disposée entre deux couches guides d'ondes (9, 10), dans lequel la couche guide d'ondes (10) opposée au substrat d'épitaxie (1) vu au départ de la couche active (4) est suivie par une couche de revêtement (8) et aucune couche de revêtement n'est disposée entre le substrat d'épitaxie (1) et la couche guide d'ondes (9) dirigée vers le substrat d'épitaxie (1).

4. Procédé selon la revendication 3,
**caractérisé en ce que**
des facettes latérales pour un laser à semi-conducteur à émission latérale (101) sont réalisées dans la succession de couches épitaxiales (6) en graver et cliver de la succession de couches épitaxiales (6).
